Europäisches Patentamt

(19) European Patent Office   (11) Publication number:   **0 053 484**

Office européen des brevets   **B1**

(12)   **EUROPEAN PATENT SPECIFICATION**

(45) Date of publication of patent specification: **16.04.86**   (51) Int. Cl.⁴: **H 01 L 21/312, H 01 L 21/324**

(21) Application number: **81305592.8**

(22) Date of filing: **26.11.81**

(54) A method for fabricating semiconductor device.

(30) Priority: **01.12.80 JP 169372/80**

(43) Date of publication of application:
**09.06.82 Bulletin 82/23**

(45) Publication of the grant of the patent:
**16.04.86 Bulletin 86/16**

(84) Designated Contracting States:
**DE GB NL**

(56) References cited:
**DE-A-2 153 441**
**US-A-4 075 367**

**IBM TECHNICAL DISCLOSURE BULLETIN, vol.
20, no. 11B, April 1978, New York, BONDUR
"Masking technique for reactive ion etching",
page 4769**

The file contains technical information
submitted after the application was filed and
not included in this specification

(73) Proprietor: **Kabushiki Kaisha Toshiba
72, Horikawa-cho Saiwai-ku
Kawasaki-shi Kanagawa-ken 210 (JP)**

(72) Inventor: **Komatsu, Shigeru
3-4-206, Iijima-danchi 527 Iijima-cho
Totsuka-ku Yokohama-shi (JP)**
Inventor: **Nakamura, Michio
2916 Yokawa Himi-shi
Toyama-ken (JP)**

(74) Representative: **Freed, Arthur Woolf et al
MARKS & CLERK 57-60 Lincoln's Inn Fields
London WC2A 3LS (GB)**

## Description

The present invention relates to a method for fabricating a semiconductor device. More particularly, the present invention relates to a method for fabricating a semiconductor device according to which adhesion of the photoresist film is improved.

Many fine-processing techniques have recently been utilized in the manufacture of semiconductor devices. Such fine-processing techniques include selective etching technique utilizing plasma etching which is known as a dry process using no etching solution. In particular, with this plasma etching, etching of silicon nitride, polycrystalline silicon, metal silicides or the like may be performed using the photoresist mask as an etching mask, unlike the wet process which requires an etching mask of silicon dioxide in addition to the photoresist film. As a result of this, the manufacturing method for the semiconductor devices may be simplified, and the manufacturing yield and reliability are improved.

However, when the insulating film is exposed to the plasma during plasma etching, the adhesion between the insulating film and the photoresist film formed thereon is significantly degraded. For example, when the second film of $Si_3N_4$, which allows selective etching on the first film of insulating material such as $SiO_2$, is subjected to plasma etching to form a desired pattern, a photoresist film is formed on the exposed surface of the insulating film and an opening is formed in the insulating film by wet etching, excessive side etching occurs. When this happens, the inner surface of the opening becomes slightly inclined, resulting in poor shape precision of the opening. When the adhesion of the photoresist film to the insulating film is worse, the photoresist film may be separated from the insulating film during the wet etching.

When this opening is an opening for diffusion of an impurity to form a resistor, the precision of the resistor element formed through this opening of poor precision becomes also poor. The characteristics of the integrated circuit device including such a resistor element also become worse. If the opening is the diffusion region of the transistor or the contact hole, the variation in the transistor characteristics becomes great. Especially when the opening is the contact hole, the junction is exposed by the opening, which may result in short-circuiting of the junction during the subsequent step of forming the electrode.

If extra space is included around the opening in the design process considering the shape precision, the integration density of the semiconductor device is considerably lowered.

It is an object of the present invention to provide a method for fabricating a semiconductor device according to which adhesion between an insulating film exposed to plasma and a resist film formed thereon is improved

It is another object of the present invention to provide a method for fabricating a semiconductor device according to which the shape precision of an opening formed in an insulating film is improved so that the characteristics, reliability and integration density of a semiconductor device fabricated thereby may be improved.

In order to achieve the above and other ends, there is provided according to the present invention a method for fabricating a semiconductor device comprising the steps of:

forming, on a first insulating film on a semiconductor substrate, a second insulating film or a conductor film;

selectively removing portions of said second insulating film or conductor film by plasma etching by using a first resist film as a mask;

removing said first resist film;

heat treating the exposed surface of said first insulating film at a temperature not lower than 250°C;

forming a second resist film on portions of said first insulating film and on the unetched portion of said second insulating film or said conductor film, said second resist film having an opening of a predetermined pattern; and

etching the first insulating film by wet etching using the second resist film as a mask for forming an opening corresponding to said opening of said second resist film.

This invention can be more fully understood from the following detailed description when taken in conjunction with the accompanying drawings, in which:—

Figs. 1 to 4 are schematic sectional views showing an embodiment of the method according to the present invention in the order of steps of formation;

Figs. 5 to 9 are schematic sectional views showing another embodiment of the method according to the present invention in the order of steps of formation;

Fig. 10 is a sectional view of an opening formed by the steps shown in Figs. 5 to 9; and

Fig. 11 is a sectional view of the opening formed by the steps shown in Figs. 5 to 9 without the heat treatment step.

The first and second insulating films are made of silicon oxide, silicon nitride, silicon carbide, or alumina. The conductor film formed on the first insulating film is made of polycrystalline silicon, a metal silicide, or a high-melting point metal.

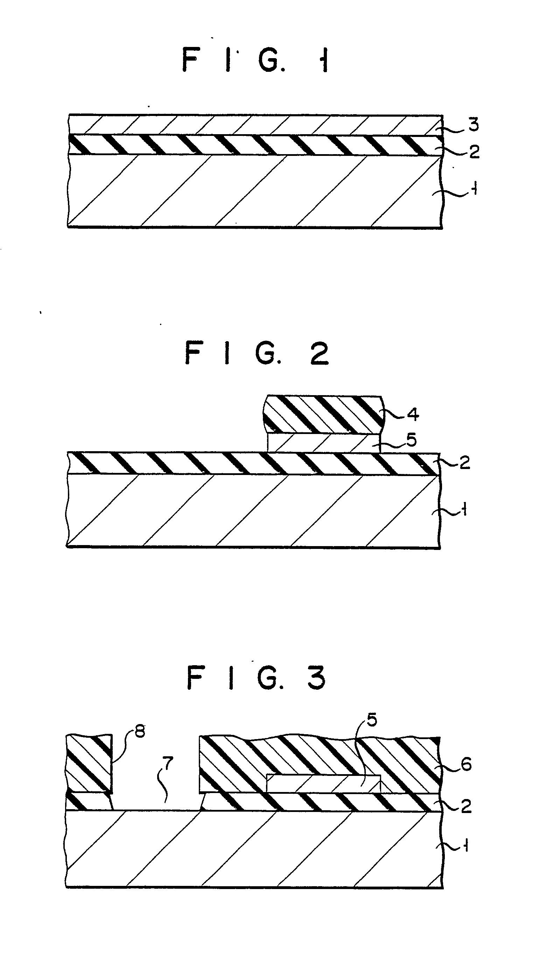

The first embodiment of the present invention will be described with reference to Figs. 1 to 4. Referring to Fig. 1, a silicon dioxide film 2 of 400 nm (4,000 Å) thickness is formed on the surface of the semiconductor silicon substrate 1. Desired elements may or may not be formed in the semiconductor substrate 1. Furthermore, an impurity of p- or n-conductivity type may or may not be implanted in the silicon dioxide film 2. A polycrystalline silicon film 3 is then deposited on the silicon dioxide film 2 to a thickness of 300 nm (3,000 Å). An impurity of p- or n-conductivity type may or may not be implanted in the polycrystalline silicon film 3.

A resist film 4 of a predetermined pattern is formed in the polycrystalline silicon film 3. The polycrystalline film 3 is selectively etched by plasma etching using a gas containing $CF_4$ and using the resist film 4 as a mask. A wiring layer 5 of polycrystalline silicon as shown in Fig. 2 is then formed. The resist film is a photoresist film of known type and may be a negative type or a positive type film.

After removing the resist film 4, the entire structure is heated at a temperature above 250°C. The temperature for this treatment is set considering the structure of the semiconductor device. The higher the temperature, the better the treatment of the surface of the first insulating film 2 exposed to the plasma and the better the adhesion between this surface and a resist film to be formed thereover. However, if an impurity is implanted in the semiconductor substrate 1, too high a treating temperature results in a change in the distribution profile of the impurity. In addition to this, too high a treating temperature results in deformation of the semiconductor substrate 1. Therefore, it is generally preferable to set the treating temperature within the range of 800 to 1,000°C. The atmosphere for the heat treatment is selected according to the characteristics of the elements formed in advance on the semiconductor substrate, the heat treating temperature, or the like. Although it is preferable to use an inert gas such as nitrogen gas, a gas mixture of nitrogen and oxygen, for example, may also be used.

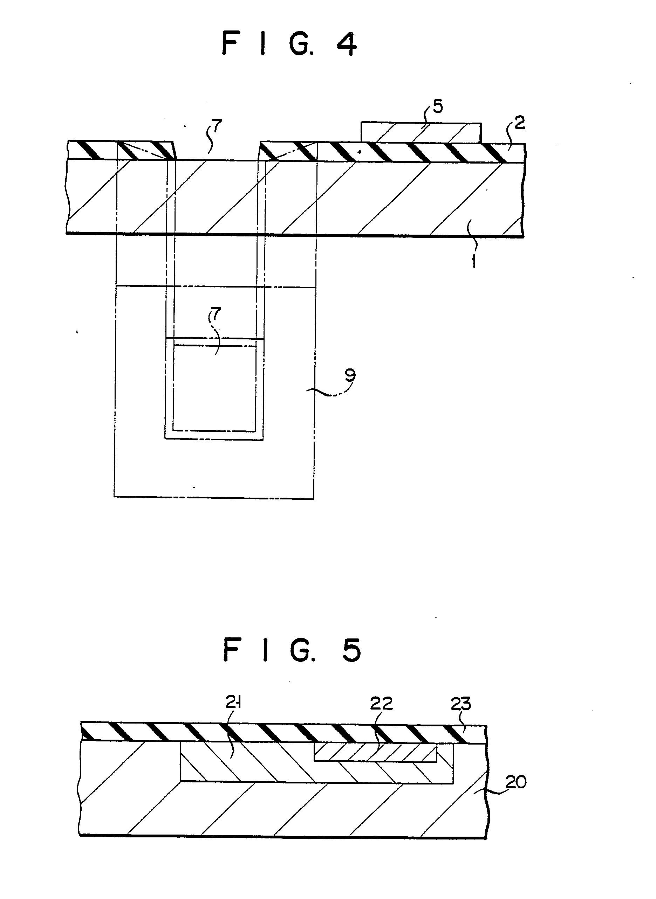

In the next step shown in Fig. 3, a resist film 6 is formed on the surface of the silicon dioxide film 2 and the surface of the wiring layer 5. A window 8 is formed in a predetermined region of the resist film 6 so as to form an opening 7 in the silicon dioxide film 2. This opening 7 is for forming a resistor or an electrode. Using the resist film 6 as a mask, the opening 7 is formed in the silicon dioxide film 2 by etching. The resist film 6 is then removed to complete the semiconductor device as shown in Fig. 4.

In a semiconductor device fabricated in this manner, the resist film is securely adhered to the silicon dioxide film. Therefore, the inner side surface of the opening 7 is formed to be substantially vertical with respect to the surface of the semiconductor substrate 1 as shown in Fig. 4. Consequently, the opening 7 can be formed with high shape precision. Since the formation of this opening does not require special etching masks other than the resist film, this step can be simplified. For the purpose of comparison, an opening 9 of the semiconductor device, which is fabricated in the same manner as the embodiment described above except that the heat treatment is not performed, is indicated by the alternate long and short dashed line in Fig. 4. If the heat treatment is not performed, the adhesion of the silicon dioxide film 2 to the resist film 6 is poor. Therefore, excessive side etching of the silicon dioxide film 2 occurs, and the area of the opening 9 becomes more than twice that of the opening 7 according to the method of the present invention.

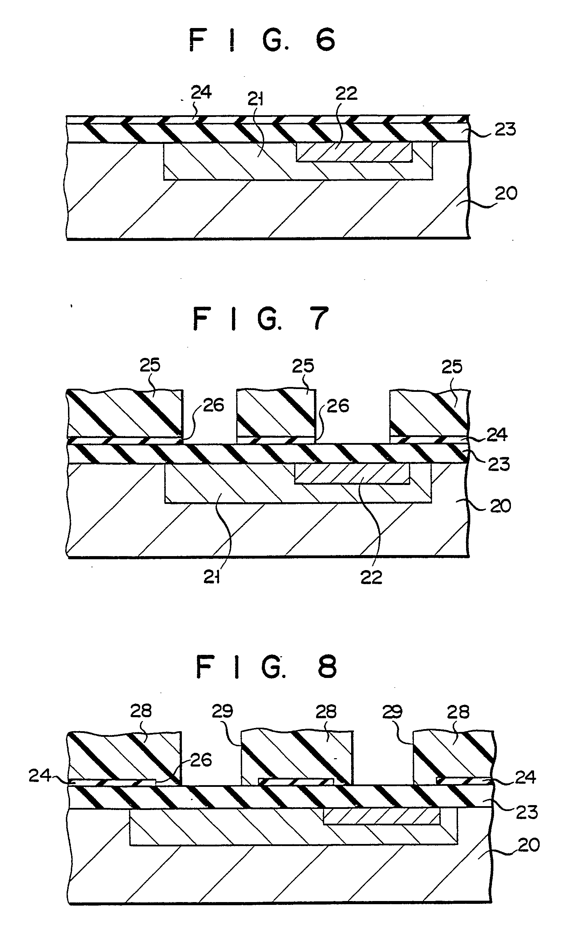

Another embodiment of the present invention will now be described with reference to Figs. 5 to 10. First, a silicon dioxide film 23 of 400 nm (4,000 Å) thickness as the first insulating film is formed on a semiconductor substrate 20 in which are formed a base region 21 and an emitter region 22 as shown in Fig. 5. Next, as shown in Fig. 6, a silicon nitride film 24 of 50 to 300 nm (500 to 3,000 Å) thickness (as the second insulating film) to be the passivation film is formed on the silicon dioxide film 23.

A photoresist film 25 is formed on the silicon nitride film 24 for forming electrodes to be connected to the base region 21 and the emitter region 22, respectively. In the next step, as shown in Fig. 7, openings 26 are formed in the silicon nitride film 24 by plasma etching using the photoresist film 25 as a mask. Thereafter, the photoresist film 25 is removed and the entire structure is heat treated at a temperature of 800 to 1,000°C in an atmosphere of a gas mixture of nitrogen and oxygen.

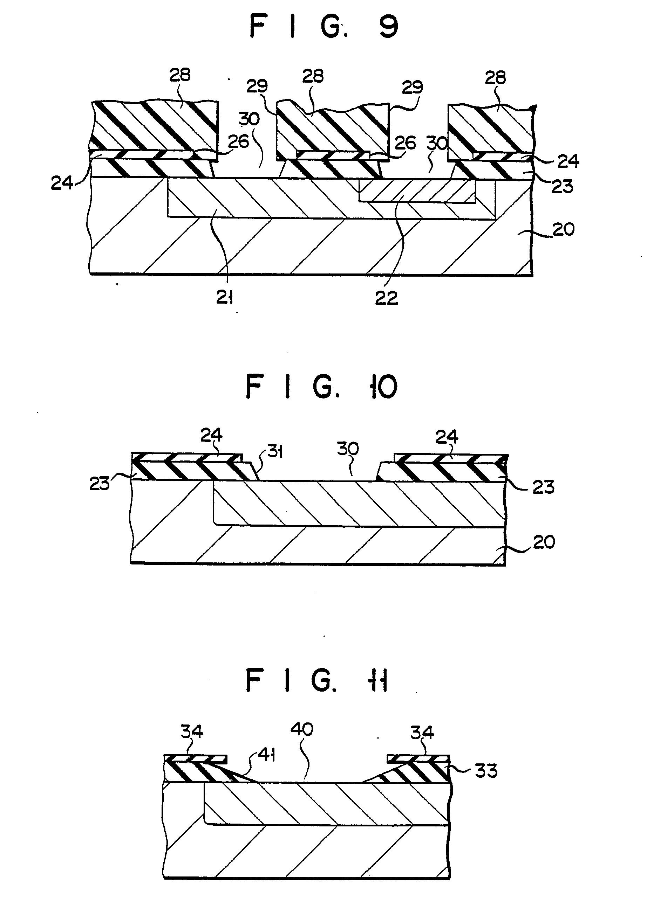

A photoresist film 28 is then deposited on the silicon dioxide film 23 and the remaining portion of the silicon nitride film 24. Then, as shown in Fig. 8, windows 29 of smaller diameter than the openings 26 of the silicon nitride film 28 are formed in the photoresist film 28 within the area of the openings 26. The silicon dioxide film 23 is etched with a solution of ammonium fluoride using the photoresist film 28 as a mask. Openings 30 are formed as shown in Fig. 9. In the final step, the photoresist film 28 is removed to complete the semiconductor device.

In the semiconductor device obtained in this manner, as shown in Fig. 10, inner side surfaces 31 of the openings 30 of the silicon dioxide film 23 are substantially vertical with respect to the surface of the semiconductor substrate 1, and the shape precision is extremely high. Furthermore, the edge of the silicon nitride film 24 does not extend over the opening 30 of the silicon dioxide film 23. Accordingly, with the method of the present invention, a semiconductor device of high reliability and high integration density may be fabricated.

For the purpose of comparison, in Fig. 11 is shown an opening 40 of a semiconductor device which is fabricated in the same manner except that the heat treatment is not performed. An inner side surface 41 of the opening 40 in a silicon dioxide film 33 is slightly inclined and the shape precision of the opening 40 is poor. The upper end of the inner side surface 41 of the opening 40 undercuts a silicon nitride film 34.

In summary, in accordance with the method of the present invention, the adhesion between the resist film and the layer for forming the opening is improved by performing heat treating after plasma etching. Therefore, a semiconductor device having an opening of high shape precision may be easily fabricated with a simplified method. In addition to this, the integration density and reliability of the semiconductor device may also be improved.

## Claims

1. A method for fabricating a semiconductor device comprising the steps of:

forming, on a first insulating film on a semiconductor substrate, a second insulating film or a conductor film;

selectively removing portions of said second insulating film or conductor film by plasma etching by using a first resist film as a mask;

removing said first resist film;

heat treating the exposed surface of said first insulating film at a temperature not lower than 250°C;

forming a second resist film on portions of said first insulating film and on the unetched portion of said second insulating film or said conductor film, said second resist film having an opening of a predetermined pattern; and

etching the first insulating film by wet etching using the second resist film as a mask for forming an opening corresponding to said opening of said second resist film.

2. A method according to claim 1, wherein the heat treating step is performed at a temperature of 800 to 1,000°C.

3. A method according to claim 1 or 2, wherein the heat treating step is performed in an atmosphere containing an inert gas.

4. A method according to claim 1, wherein said first insulating film is made of silicon dioxide.

5. A method according to claim 1, wherein said second insulating film is made of silicon nitride, silicon carbide, or alumina.

6. A method according to claim 1, wherein said conductor film is made of polycrystalline silicon, a metal silicide, or a high-melting point metal.

7. A method according to claim 1, wherein said resist films are photoresist films.

## Patentansprüche

1. Verfahren zur Herstellung einer Halbleitervorrichtung, umfassend die Schritte:

Bildung eines zweiten Isolationsfilmes oder Leiterfilmes auf einem ersten Isolationsfilm auf einem Halbleitersubstrat,

Selektives Entfernen von Bereichen des zweiten Isolationsfilmes oder Leiterfilmes durch Plasmaätzen unter Benutzung eines ersten Widerstandsfilmes als Maske,

Entfernen des ersten Widerstandsfilmes,

Wärmebehandlung der freigelegten Oberfläche des ersten Isolationsfilmes bei einer Temperatur, die nicht geringer ist als 250°C,

bildung eines zweiten Widerstandsfilmes auf Bereichen des ersten Isolationsfilmes und dem ungeätzten Bereich des zweiten Isolationsfilmes oder des Leiterfilmes, wobei der zweite Widerstandsfilm eine Öffnung mit einem vorgegebenen Muster aufweist, und

Ätzen des ersten Isolationsfilmes durch Naßätzen unter Verwendung des zweiten Widerstandsfilmes als Maske zur Bildung einer Öffnung entsprechend der Öffnung des zweiten Widerstandsfilmes.

2. Verfahren nach Anspruch 1, dadurch gekennzeichnet, daß der Wärmebehandlungsschritt bei einer Temperatur von 800 bis 1000°C ausgeführt wird.

3. Verfahren nach Anspruch 1 oder 2, dadurch gekennzeichnet, daß der Wärmebehandlungsschritt in einer Atmosphäre ausgeführt wird, die ein träges bzw. neutrales Gas enthält.

4. Verfahren nach Anspruch 1, dadurch gekennzeichnet, daß der erste Isolationsfilm aus Siliziumdioxid hergestellt ist.

5. Verfahren nach Anspruch 1, dadurch gekennzeichnet, daß der zweite Isolationsfilm aus Siliziumnitrid, Siliziumcarbid oder Aluminiumoxid hergestellt ist.

6. Verfahren nach Anspruch 1, dadurch gekennzeichnet, daß der Leiterfilm aus polykristallinem Silizium, einem Metallsilizid oder einem Metall mit einem hohen Schmelzpunkt hergestellt ist.

7. Verfahren nach Anspruch 1, dadurch gekennzeichnet, daß die Widerstandsfilme Photowiderstandsfilme sind.

## Revendications

1. Procédé de fabrication d'un dispositif semiconducteur comprenant les opérations suivantes:

former, sur une première pellicule isolante se trouvant sur un substrat semiconducteur, une deuxième pellicule isolante ou une pellicule conductrice;

retirer sélectivement des parties de ladite deuxième pellicule isolante ou pellicule conductrice en pratiquant une incision par plasma utilisant comme masque une première pellicule de réserve en agent sensible;

retirer ladite première pellicule de réserve en agent sensible;

traiter thermiquement la surface exposée de ladite première pellicule isolante à une température qui n'est pas inférieure à 250°C;

former une deuxième pellicule de réserve en agent sensible sur des parties de ladite première pellicule isolante et sur la partie non incisée de ladite deuxième pellicule isolante ou ladite pellicule conductrice, ladite deuxième pellicule de réserve en agent sensible possédant une ouverture ayant une configuration prédéterminée; et

inciser la première pellicule isolante en procédant à une incision par voie humide utilisant comme masque la deuxième pellicule de réserve en agent sensible afin de former une ouverture correspondant à ladite ouverture de ladite deuxième pellicule de réserve en agent sensible.

2. Procédé selon la revendication 1, où on effectue l'opération de traitement thermique à une température de 800 à 1 000°C.

3. Procédé selon la revendication 1 ou 2, où on effectue l'opération de traitement thermique dans une atmosphère contenant un gaz inerte.

4. Procédé selon la revendication 1, où ladite première pellicule isolante est faite de dioxyde de silicium.

5. Procédé selon la revendication 1, où ladite deuxième pellicule isolante est faite de nitrure de silicium, de carbure de silicium, ou d'alumine.

6. Procédé selon la revendication 1, où ladite pellicule conductrice est faite de silicium polycristallin, d'un siliciure de métal, ou d'un métal à haut point de fusion.

7. Procédé selon la revendication 1, où lesdites pellicules de réserve en agent sensible sont des pellicules photosensibles.

# F I G. 1

# F I G. 2

# F I G. 3

# F I G. 4

# F I G. 5

# F I G. 6

# F I G. 7

# F I G. 8

# F I G. 9

# F I G. 10

# F I G. 11